# EUROPEAN PATENT SPECIFICATION

(11) **EP 2 235 741 B1**
(45) Date of publication and mention of the grant of the patent: **12.03.2014**
(21) Application number: 09705170.0
(22) Date of filing: 30.01.2009
(51) Int. Cl.: H01L 21/283, H01L 51/00, H05K 1/03, H05K 3/38

(54) **PROCESSING OF ELECTRIC AND/OR ELECTRONIC ELEMENTS ON CELLULOSIC MATERIAL SUBSTRATES**
HERSTELLUNG ELEKTRISCHER UND/ODER ELEKTRONISCHER BAUTEILE AUF ZELLULOSE-HALTIGEN SUBSTRATEN
TRAITEMENT D'ÉLÉMENTS ÉLECTRIQUES ET/OU ÉLECTRONIQUES SUR DES SUBSTRATS DE MATÉRIAU CELLULOSIQUE

(30) Priority: 31.01.2008 PT 10395108
(43) Date of publication of application: 06.10.2010
(73) Proprietor: Ydreams - Informática, S.a., 2829-516 Caparica (PT); Faculdade De Ciências E Tecnologia Da Unl, 2829-516 Caparica (PT)
(72) Inventor: FORTUNATO, Elvira Maria Correia, P-2829-516 Caparica (PT); MARTINS, Rodrigo Ferrão de Paiva, P-2829-516 Caparica (PT); CÂMARA, António da Nóbrega de Sousa da, P-2829-516 Caparica (PT)
(74) Representative: Alves Moreira, Pedro
(86) International application number: PCT/PT2009/000008
(87) International publication number: WO 2009/096802

(56) References cited:
- US-A1- 2006 189 113
- US-A1- 2008 012 151
- CHAN-JAE LEE ET AL: "29.2: Top Emission Organic EL Display on Paper Substrate" 2004 SID INTERNATIONAL SYMPOSIUM. SEATTLE, WA, MAY 25 - 27, 2004; [SID INTERNATIONAL SYMPOSIUM], SAN JOSE, CA : SID, US, vol. XXXV, 25 May 2004 (2004-05-25), pages 1005-1007, XP007011892

## Description

### FIELD OF INVENTION

The present invention generically refers to the use of paper (cellulosic material) as substrate for the manufacturing of simple, discrete and/or integrated electric and/or electronic circuits, wherein conductive contacts and active devices to be used are fabricated directly on paper. The present invention is based on atomic/nano-scale technologies applied to electric and electronic materials, namely metals, oxides, dielectric materials (both simple and with high dielectric constant) and semiconductors, which allow the processing, on treated or untreated paper surfaces, of metallic contacts (with resistivity lower than 10⁻⁴ Ω.cm) for the connection of discrete electronic elements, highly conductive (with conductivity between 10²Ω⁻¹.cm⁻¹ and 10⁴ Ω⁻¹.cm⁻¹) transparent oxides, conductive semiconductor oxides (conductivity under 10⁻¹⁴-10² Ω⁻¹.cm⁻¹), electric materials with high resistivity (above 10¹¹ Ω.cm) and relative dielectric constant between 1.4 and 35, organic conductors and semiconductors for producing electronic devices, such as thin film transistors, organic light-emitting diodes, diodes, bridge rectifiers, gas sensors, optical sensors, biosensors, ultraviolet detectors.

### BACKGROUND OF THE INVENTION

Next, we describe the state-of-the-art and prior patents which may be related to the present invention.

In both Research and Development (R&D) and applications, it is unaware any activity that is close or corresponds to the object of the present invention, in its aspects of integrated process, resulting product and applications.

From the conducted search we found the following patents, which are close to the present invention but do not include the use of a cellulosic substrate.
1. US patent 3 617 372, dated 1967, refers to electro-conductive paper, for achievement of electro-static images, with application in the area of bulk paper manufacturing, causing it to contain polymeric chains of hydroxyethyl and hydroxypropyl groups, so as to adapt the paper for image-capture functions, and to provide contactless printing. This patent is not in force. It related to the constituent in volume of the substrate and not to the use of a substrate for the integration of devices.
2. JP2003123559, "FORMING METHOD AND ITS DEVICE FOR TRANSPARENT CONDUCTIVE FILM, TRANSPARENT CONDUCTIVE FILM AND ELECTRONIC PAPER" - is related to the production of transparent conductive films at low temperatures, namely ITO (or ZnO), by (CVD) method assisted by a plasma using the gaseous forms of indium iodate and tin chloride (Zinc Nitrate, (Zn(NO3) 2.6H2O)), in an oxygenated atmosphere, with or without an inert gas such as Argon, deposited over polythiophene polymeric membranes or another organic material, for use in so-called electronic paper (e-paper). That is, the possibility of rewriting alphanumeric characters or images on a flexible film based on a transparent conductive oxide, deposited on an organic substrate. In this case, it is intended, for instance, that the conductive transparent oxide serves as an electrode for the application of electric fields for controlling image tone, for instance through the orientation of liquid crystals. This patent covers the film manufacturing process, the system used thereto and the physical-mechanical characteristics of the obtained films, such as adhesiveness. That is, the patent goal is the production over organic substrates of conductive oxides to be used simply as electrodes, the patent not encompassing the processing of said materials over cellulosic or composite paper.
3. US 2006/0132894 - is related to the deposition of transparent conductive oxides on both sides of electronic paper, aiming at applications similar to those described in patent JP2003123559. That is, the adaptation of technologies used in displays, namely liquid crystal, for new displays produced over organic substrates. Thus, the claims of this patent are in the area of the devices used and in how to process and retain an image on flexible organic substrates, including the control of non-conductive particles placed inside the substrate itself, or under the produced oxides, with the capacity of altering their transmittance, through the application of an electric field. This is not the field of application of the present invention. Additionally, transparency is suggested as an application of carbon nanotubes, which are not in use in the present invention.
4. CA682814 "ELECTRICALLY CONDUCTIVE PAPER, AND METHOD OF MAKING IT" - concerns the bulk processing of conductive paper, namely referring to the inclusion in the paper of metal-coated fibers or not, randomly dispersed in a cellulosic matrix. This is not the field of application of the present invention, which does not involve manipulating the structure of paper.
5. CA767053 "ELECTRICALLY CONDUCTIVE PAPER" - refers to the coating of cellulosic paper in conductor volume, coated with an insulating photo-conductive material associated to the incorporation of zeolites, and able to ensure a resistivity below 10¹² Ω.cm, in view of the development and maintenance of electrostatic charges for printing information. This is not the field of application of the present invention. The deposition technique is different.
6. CA898082 "POLYMERIC QUATERNARY DERIVATIVES OF 4-VINYL PYRIDINE IN ELECTRICALLY CONDUCTIVE PAPER" - aims to the use of quaternary polymers able to receive photoconductive coatings capable of producing electrostatic copy paper. This is not the field of application of the present invention.
7. CA922140 "ELECTRO-CONDUCTIVE PAPER" - refers to electro-conductive paper with at least 75% of its constitution with polymers, practical in image reproduction techniques. This patent covers all the compositions containing radical structures of the type:

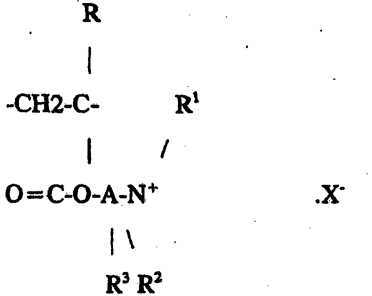

This is not the field of application of the present invention.

From the above-mentioned, it is concluded that, both in terms of product and processes mentioned in the present invention, there is not, that we are aware of, any published patent application or result.

The referred patents and references correspond to the state-of-the-art in the area of the present invention, and with which there are some peripheral contact points, both in terms of processes and materials used as conductors on plasticized surfaces, and of the fact that processes, in some cases, also take place at room temperature. However, the technologies used in the present invention are distinct - while they may contemplate the process of manufacturing by plasma-assisted chemical vapor deposition that is not the object of the present invention, the used method is PVD and not the CVD one, whose application in cellulosic substrates, or derivatives and compounds thereof is unknown. Also, the resulting product is completely new, as there are not available in the market today electric and/or electronic components based on ordinary paper.

Chan-Jae Lee et al: "29.2. Top Emission Organic EL Display on Paper Substrate", 2004 SID International Symposium, shows an OLED an a parylene coated ink-jet paper substrate.

The present invention being defined in claim 1 uses an integration of technologies, with the goal of obtaining electric and/or electronic components based on electric and/or electronic systems, deposited on and/or integrated with cellulosic or bio-organic paper. It is unknown, in laboratory research or product, paper displays, or interactive maps made from paper, or dynamic indicators made from paper. These are the central object of the present invention, in which there comes together a hybrid but still monolithic quality, in terms of the integration of electronic elements which produce new effects and add new value to the application of the invention, which is not foretold in systems comprised within the state-of-the-art.

### BRIEF DESCRIPTION OF THE DRAWINGS

Figure 1a. Schematic view of a low-complexity printed circuit.
Figure 1b. Schematic view of a high-complexity printed circuit.
Figure 2a. Schematic view of the basic structure of an Organic Light-Emitting Diode, OLED.
Figure 2b. Schematic view of an advanced OLED structure.
Figure 2c. Schematic view of the operating mode of an OLED.
Figure 3a. Schematic view of a thin film transistor, TFT, with top gate.
Figure 3b. Schematic view of a TFT, with bottom gate.
Figure 3c. Schematic view of a TFT, with planar configuration.
Figure 3d. Schematic view of a TFT, with zigzag configuration.
Figure 4. Schematic view of a TFT with memory.
Figure 5. Schematic view of a metal/semiconductor bridge rectifier.
Figure 6a. General schematic of an active matrix to address pixels.
Figure 6b. General schematic of an active matrix to address an array of OLEDs.
Figure 6c. General scheme of an active matrix - manufacturing steps and masks to be used.
Figure 7. Schematic example of an integrated system for information control and display.

### DETAILED DESCRIPTION OF THE INVENTION

The present invention is based on a set of physical, chemical and physicochemical deposition technologies of thin films at the atomic scale, both reactive and non-reactive, carried out close to room temperature, namely:
- cathodic pulverization by direct current or radiofrequency;
- resistive thermal deposition, or by electron cannon in vacuum;
- chemical vapor deposition assisted by radiofrequency or UHF plasma.

These techniques allow the controlled growth of films with thicknesses between 10 nm and 1000 nm, made of organic and inorganic materials, without damaging the paper or the electronic and optical performance of the deposited materials.

### CORNERSTONES OF THE INVENTION

In terms of interactive applications with a functional support made of paper, or of paper with non-static functions, there are not many previous embodiments other than coatings and the introduction of conductive fibers in the paper, whose functional result is passive. The present invention has topic interest in the re-definition of the concepts of e-book and e-paper, from an electronic format previously accessible only through separate equipment (e.g. a computer) to a superior level of integration of such functionalities in the traditional format of a book, and furthermore in paper itself. With the information technology revolution, embodied in the dissemination of personal computers and consolidated in their connection via the Internet, recording on paper in a general perspective has become regarded as a low-technology, and thus obsolete, solution. The present invention rehabilitates paper as a high-technology solution.

The development of printing techniques has made possible the manufacturing of integrated circuits resorting solely to additive techniques, which can be executed without resorting to clean rooms and micro-electronic labs. This kind of technology facilitates the manufacturing of medium-resolution displays, and moreover of a big branch of electronics: macroelectronics.

This development allows the achievement of low cost materials and electronic disposable devices and allows for the introduction of a dynamic component to current paper formats, e.g., dynamic paper maps, insertion of dynamic recreational components in reading, e.g., moving pictures, informative notes, automatic search on events related to news that are being read, allowing the direct interaction of a reader with the same. Furthermore, it allows the user of the paper to draw/write in a dynamic fashion. In order to reach these goals, it is fundamental that one can draw, design and fabricate over paper the same type of circuits that are nowadays made on substrates such as plastic. This use of paper is revolutionary in view of the traditional use: static information, with no added value.

To reach these goals, it is necessary to develop nano-scale technologies that allow the production of particles, with exceptional properties, over paper. To this effect, it is necessary to combine scattered technologies and to adapt them to 4 requirement levels:
- manufacturing processes;
- functional characteristics of materials and devices;
- products;
- systems.

Regarding manufacturing processes, the paper surface is prepared in a controlled atmosphere for the deposition processes. Unlike conventional deposition processes, it is guaranteed that the entire deposition process is done at a temperature close to room temperature, that there is no overheating derived from the deposition process itself, and also that the deposited materials meet adherence, mechanical elasticity and chemical stability, and electronic and optical quality parameters.

To obtain the aforementioned characteristics, the metals to be used are: silver, aluminum, copper, titanium, gold and platinum, to be used in the processing of metallic contacts and in metal-semiconductor bridge rectifiers. Furthermore, the process of deposition of any organic thin film with metallic conductivity characteristics is also included.

For semiconductors, the inorganic materials to be used are amorphous nano-crystalline silicon, doped and non-doped; semiconductor oxides, simple, binary, ternary and quaternary in single or multi-layer, for instance, ZnO(Ga), with properties that range from dielectric (resistance over 10¹¹ Ω.cm) to highly-conductive ohmic contacts (entre 10²-10⁴ Ω⁻¹ cm⁻¹).

Regarding organic semiconductor materials, the most relevant are: tetracene, pentacene, copper phthalocyanine, titanium oxide phthalocyanine and zinc phthalocyanine, among others.

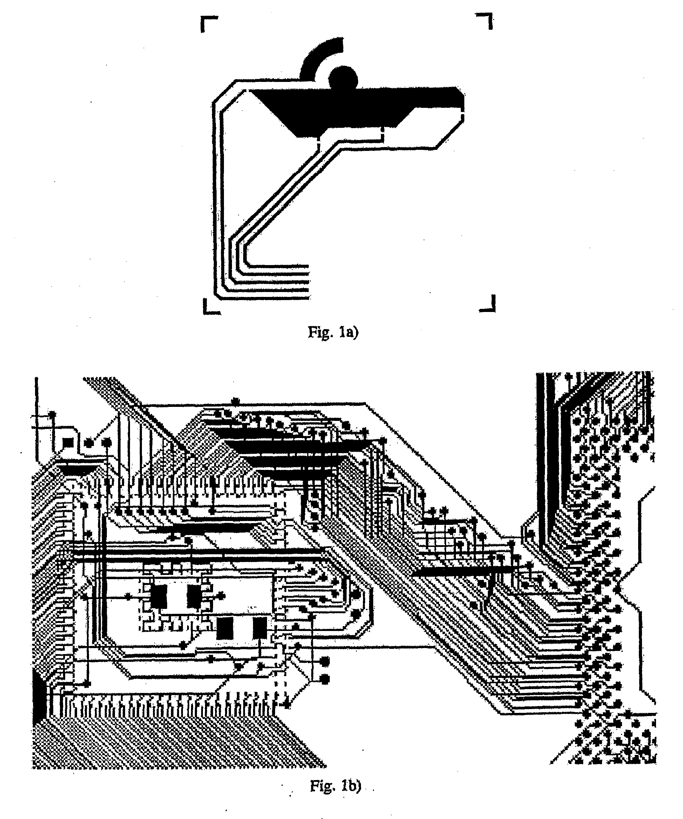

In functional terms, it is sought to deposit conductive and transparent traces (or any type of "design/layout") based on metals or metallic oxides at room temperature, with the purpose of linking electronic, hybrid or integrated elements on paper for purposes of polarization, signal carrying and signal reception. Figure 1 represents an example of the kind of matrix to be used.

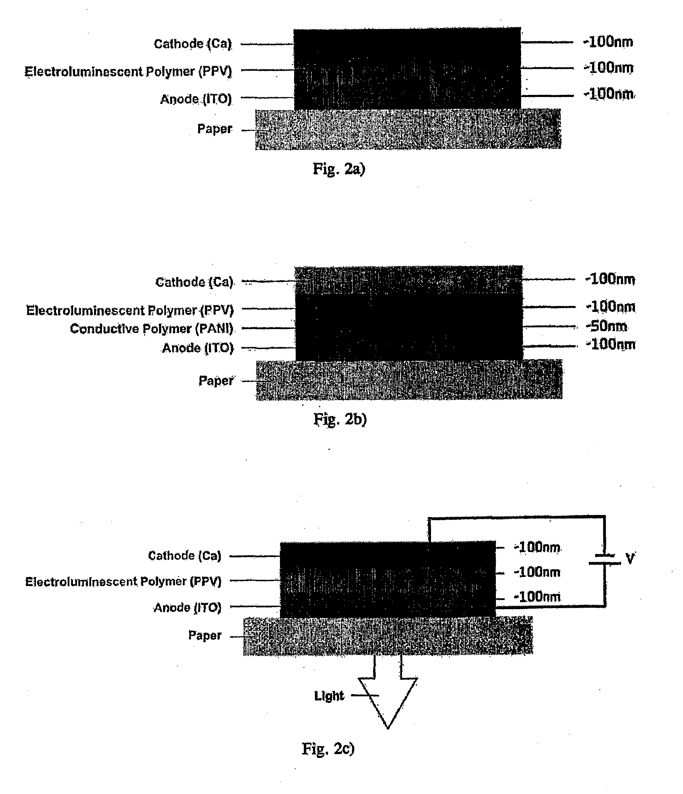

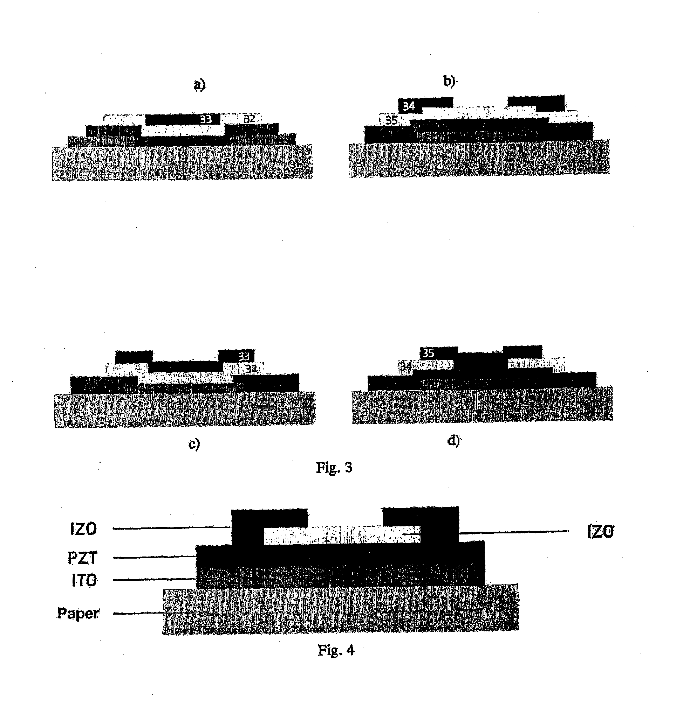

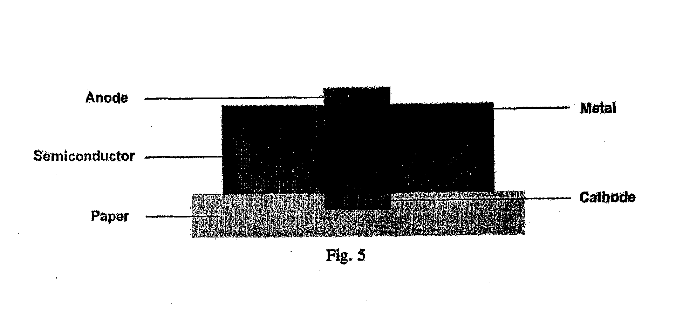

Regarding devices, it is sought to:
1. deposit organic light-emitting diodes using inkjet-compatible technology, to be interlinked by conductive traces as aforementioned (figures 2 and 3).
2. deposit thin film transistors (of types n and p), based on semiconductor oxides, with the ability to may serve as switching keys as well as serve as information conducting/receiving devices. These devices have a constitution as shown in figure 3, top or bottom gate, with the channel (active semiconductor) deposited on top of or below the dielectric. These devices will have mobilities in excess of 0.5 cm²V⁻¹s⁻¹, on/off ratios greater than 10⁵ and will work both in enrichment and depletion modes, this is, needing the application of an electric potential to be activated, or being in an activated state without any application of electric potential;
3. thin film transistors with memory effect (see Figure 4), in which the dielectric material is substituted by a ferroelectric or ferromagnetic material, of the PZT or SBT or organic types;
4. bridge rectifiers based on semiconductors from active oxides and silicon (see Figure 5);
5. CMOS devices.

Regarding systems, it is sought to fabricate integrated circuits:
- of low complexity (e.g.: printed circuits for connecting electronic components, such as light-emitting diodes, switching keys, power supply units, transistors, optical and radio receivers, switches, memories, microprocessors, recorders, integrators, differentiators, sensors, resistors, capacitors, inductors - all these components as both thick and thin film);
- of medium complexity(e.g.: addressing matrixes for flat displays; photosensor matrixes; gas sensor matrixes; colour sensor matrixes; encoders; all in an integrated form, this is, processed on paper itself);
- of high complexity (e.g.: addressing systems, with integrated circuits, at nano-scale, of single or multi-layer, fully processed on paper);

The purpose of the present invention is to generate electric and/or electronic components based on a new concept of paper, in which paper is no longer just a trivial means of communication, but also becomes a communication agent, with the following prospective, non-exclusive, different level examples:
- Cellulosic or bio-organic based electronic paper (paper incorporating electronic elements);
- Cellulosic or bio-organic based intelligent paper (paper with the ability to reproduce non-traditional content, e.g. movies);
- Cellulosic or bio-organic based memory paper (circuits integrated on paper, with the ability to store information, preferences);
- Cellulosic or bio-organic based interactive paper (with a reaction programmed in relation to a stimulus, e.g. a light that is activated when a certain area of the paper is pressed);
- Cellulosic or bio-organic based security paper (allowing new forms of authentication, e.g., by electronic means, e.g., for application to bank notes, checks);
- Cellulosic or bio-organic based paper smart tags (e.g., reactive to the presence of other tags).

It is not comprised in any known patents, or in the state-of-the-art, cellulosic or bio-organic based paper for writing, henceforth simply referred to as "paper", with the aforementioned functionalities, or the ability to perform deposition of traces, devices and systems directly integrated on paper. The conducted search in several patent information databases revealed that none of the processes of paper functionality which are object of the present invention are described in the state-of-the-art.

The concept of the present invention is new and, while its embodiments are based in technologies which by themselves are known, their novelty resides in their specific and complex integration of a new set of purposes, resulting in an entirely new product.

### DETAILED DESCRIPTION OF THE PREFERRED EMBODIMENT OF THE PRESENT INVENTION

The present invention consists in the adequation of deposition processes compatible with a cellulosic or bio-organic paper substrate, over which electronic materials and devices of diverse degrees of complexity are integrated, and where three fundamental concepts are paramount:
1. The adequation of electronic systems to the visual nature of the product, the circuits being able to be installed on the surface of the hidden face of the paper (rendered "hidden"), being integrated on the visible face ("reading side"), or being simple dynamic tags (animations or effects for attracting attention) of the packages. In the first case, the circuits to implement can be opaque, while in the second case they will be transparent (transparent electronics).
2. The non-interference of the electronic elements with the printed graphic elements, so as to preserve their graphic identity, means that all the elements will be semiconductor-based, doped or not, of high optical gap, for instance, semiconductor oxides or organic semiconductors, to guarantee the suitable transparency. Furthermore, all materials and devices to be used will have to be integrated in a monolithic fashion with the paper, this is, as if they had started off being part of the paper: all elements shall be deposited in the form of thin film, with dimensions in the range of nanometres.
3. The flexibility about the paper printing stage in which they occur, before or after the paper printing. This means that the products to be developed may already exist integrated on the paper or packages thereof at the exit of factory, or being integrated in the latter after their graphical printing.

In all the aforementioned cases, it must be noted that the manufacturing process does not damage the paper in any way. To achieve this, all processes are conducted at low temperatures, especially those occurring on the paper surface.

The present invention is susceptible of different configurations according to specific application. The present invention allows the use of paper as substrate for electronic circuits of low, medium and high complexity, from plain electrical signal conductor to transmitting, receiving and displaying information, with the ability to interact with the user. Another foreseen logical application is as a recreational element for attracting the attention of buyers and users.

From the above, the present invention presents a set of functions and techniques which, by new innovative processes, allows for new products and systems which integrate paper as base material for the deposition of conductive traces, electronic devices and integrated circuits; and which are not comprised in the state-of-the-art.

Another advantage of the present invention is that it allows, in an automatic way, to influence the consumers at the moment of purchase. The consumer is surprised by the system which attracts its attention to a specific product or service displayed at the point of sale, influencing the consumer at the moment of purchase.

Another technical advantage of the present invention is the fact that it may provide the user with referencing functions and dynamic use, e.g.:
- interactive maps which aid in the process of locating areas, services, routes, places and other points of interest in a common map;
- page holders for books, which allow memorize the page in which a given reading was interrupted;
- animation of explanatory images for a section of the reading;
- dynamic promotional tags;
- microprocessors connected to the cover or spine of a book which, when activated, memorize or relay information related to the document in question.

Figure 1 is an illustration of a conductive printed circuit, for connecting different electronic elements, of low (a) and high (b) complexity. In this case, the lithographic process used resorts to masks (circuit drawings) made of vinyl with a strong adhesion to paper, providing for maximum trace definition and contrast. The tolerance to be observed in trace separation is between 100-50 micrometers. The thickness of the films varies between 100 nm and 1000 nm, as a function of the material to be used and the maximum resistance allowed of the produced traces, so as to diminish energy consumption and avoid the limitation of the flowing electric current, and also to diminish the signal/noise ratio of the information which the traces may carry. In the case of metals (opaque), the choice falls on good conductors (Cu, Ag, Sn, Al, Au and their alloys). In the case of doped semiconductor oxides the materials to be used are: ZnGaO; InSnO; ZnAlO; SnO, InZnO, IMO, with different stoichiometries and compositions.

### A - MANUFACTURING PROCESS

As a first stage, regardless of the type and weight of the paper used, it is necessary to prepare and condition the surface, taking into consideration its texture and the need to fabricate continuous films. Such is achieved through:
a) Subjecting the surface to be printed to UV treatment, for 10 minutes;
b) Subjecting the surface to a vacuum treatment, which consists in subject the surface, before deposition process, to a DC or RF discharge in an Argon, Nitrogen or Xenon atmosphere under pressures between 1-10² Pa, for 5 minutes, using power densities between 0.1-3 Wcm⁻².
c) Cleaning the surface with a nitrogen/hydrogen jet to remove released nano-particles and activate the surface (that being the function of the Hydrogen contained in the mixture with nitrogen).

Once the surface has been prepared, it is transferred to another environment where different stages will take place, depending on the final goal.

### B - PROCESSING OF PRINTED CIRCUITS

A first aspect of the present invention corresponds to the use of passive conductive circuits (low or high complexity printed circuits, as exemplified in Figures 1a and 1b), made up from:
a) Metal (Cu, Ag, Sn, Al, Au and their alloys), produced by the set of techniques mentioned below:
   I) THERMAL EVAPORATION IN VACUUM, resistive or by electron cannon, using pressures lower than 10⁻³ Pa and systems in which the substrate temperature is controlled by cooling. The minimum thicknesses to be used are around 100 nm. Growth ratios vary, the lower ones being for continuous processes (about 5mn/min) or for step-by-step processes (about 50 nm/min). The distance from substrate to source is determined as a function of the dimensions of the sheet of paper, which may vary between 20 and 100 cm. In the latter case, the pressure to use should be less than 10⁻⁴ Pa. In any of the cases, the atmosphere was rendered inert, by the flow of an Argon flux and by pre-heating the interior walls of the chamber, for degasification. This process can be implemented and executed continuously (roll to roll).
   II) MAGNETRON-ASSISTED CATHODIC PULVERIZATION (DC or RF), executed in an Argon atmosphere, with controlled temperature of the substrate (cooling), under pressures ranging from 1 to 10⁻¹ Pa, and where the distances between substrate and metallic target vary between 5 and 15 cm, as function of the dimensions of the target to be used and the dimensions of the paper sheet. Growth ratios vary, the lower being for continuous processes (about 5nm/min) or for step-by-step processes (about 50 mn/min).
b) Conductive and transparent oxides (ZnGaO; InSnO; ZnAl0; SnO, InZnO, IMO, with different stoichiometries and compositions) produced by the set of techniques mentioned below:
   I) MAGNETRON-ASSISTED CATHODIC PULVERIZATION (DC or RF), using a reactive atmosphere and metallic or ceramic substrates, with different compositions and degrees of purity around 99.97%. The pressures to use vary between 1 and 10⁻¹ Pa, and the partial oxygen pressure varies between 10⁻⁴ and 10⁻² Pa; and the distances between substrate and target vary between 5 and 15 cm, as a function of the dimensions of the target to be used, and the dimensions of the paper sheet. Growth ratios vary, the lesser being for continuous processes (about 5 nm/min) or step-by-step processes (about 20 nm/min). The thicknesses to be used are in the range of 100-400 nm, as a function of the length of the traces and the base resistivity of the processed materials (between 6X10⁻³ and 4X10⁻⁴ Ω.cm).
   II) THERMAL EVAPORATION IN VACUUM, resistive or by electron cannon, from ceramic/oxide materials containing the metallic elements to be deposited and which process takes places under pressures lower than 10⁻³ Pa, following the procedures mentioned above for this technique. In this case, growth ratios are about a factor of 5 applied to the ones previously mentioned.

Whatever the manufacturing way may be, the tolerance to use in the separation between traces is 100-500 micrometers. Width of the traces is a function of the intended degree of integration and of the current flowing through them, and it can be characterized in that it will not be less than 200 nm (metal) or more than 3 mm, in general terms. For the manufacturing of the printed circuits masks are used, such as from poli-vinyl or other compatible and/or moldable polymers, placed directly over the substrate, so that optimal contrast ratios are reached, regarding thickness profiles. These printed circuits serve to connect discrete electronic circuits, such as organic light-emitting diodes or switching keys, or to integrate devices to be deposited/produced directly on the surface of the paper.

### C - PROCESSING OF ACTIVE DEVICES

In this section the devices that can be directly fabricated on a paper surface to optimize their functionalities and allow the desired interaction are described. Here follows, shortly, some examples of devices and the method by which they are fabricated and composed.
a) Organic light-emitting diodes (OLEDs). Figure 2 is a diagram of organic light-emitting diodes (OLED) to be deposited on paper. The diagram includes the different OLED constituents and an example of the type of material to be used, giving as examples the case of a basic architecture, and other of a relatively advanced architecture. In this specific case, the OLED is produced by the heated inkjet technique being outside claim 1, comprismg the following stages: (i) deposition of a conductive, transparent contact, with high efficiency, for instance, IZO or ITO, whose geometry and placement is executed simultaneously with the layout of the traces of the printed circuit (see Figure 1); (ii) next there is the deposition of a hole-carrying organic film (TPD, for example, N,N'-diphenyl-N,N-bis[3-methylphenyl]-1,1' biphenyl-4,4'diamine); (iii) the deposition of the electroluminescent material as, for instance Alq3 (tris-8(hidroxy quinolinolate) from Aluminum III); (iv) finally the Aluminum is deposited to perform the last contact. Figure 2a exemplifies the operating mode of these devices.
b) Thin film transistors. Their function is to act as switching keys for signal addressing, and also serve as signal conducting circuits. Figures 3 are schematic views of thin film transistors (TFT) with different configurations (bottom gate, top gate, planar and arranged in zigzag). The materials to be used as active semiconductors are: ZnO; ZnO(Al); SnₓO_{y}(F); ZnO(N); OCuₓ; InOₓ; Ocdₓ; OAg; InₓMo_{y}O_{z}; SnₓIn_{y}O_{z}; In_{z}Zn_{y}Oₓ; ZnₓGa_{y}O_{z}; InₐZn_{b}Ag_{c}O_{d}; InₐZn_{b}Zr_{c}O_{d}; InₐZn_{b}Ga_{c}O_{d}; InₐZn_{b}Cu_{c}O_{d}; InₐZn_{b}Cd_{c}O_{d}; InₐZn_{b}Sn_{c}O_{d}; InₐZn_{b}Mo_{c}O_{d}; Hf0ₓ; TiOₓ; TaOₓ; AlₓO_{y}; with exceptional qualities, which range from dielectric (resistivity higher than 10¹¹ Ω.cm) or behaving as a highly transparent ohmic contact (between 10¹-10⁴ Ω⁻¹.cm⁻¹). 31 is the substrate (paper); 32 the dielectric; 33 the gate electrode; 34 the source/drain and 35 the channel, based on a covalent semiconductor as silicon or a singular or multi-compound ionic acid, such as GIZO, or IZO, or similar.
   The technology to use includes the production of TFTs on paper, using active semiconductor oxides, where the drain and source regions are metallic (titanium). The diagram in figure 3a) shows a TFT with bottom gate, where the active layer is an oxide (IZO, GIZO, ZIMO, IZnCuO, or a silicon oxide) and the drain is made of the same materials, only working as degenerated semiconductors (contacts) or highly doped (in the case of Si). Figure 3b) shows the same structure as before, with top gate. The highly transparent TFTs where the IZO properties are controlled, so that it functions as source/drain, with thicknesses between 100-200 nm and resistivity lower than 10⁻³ Ω.cm; or channel, with thicknesses between 10-20 nm and resistivity higher than 10²Ω.cm, using dielectrics based on materials of high dielectric constant such as ATO, TaOx and thicknesses between 100-250 nm, for the cellulosic substrate, are produced by the following set of techniques:
   I - MAGNETRON-ASSISTED CATHODIC PULVERIZARION (DC or RF), wherein the electronic properties of the semiconductor oxides to be used are regulated through the partial oxygen pressure to be used during the growth process of the oxides (as the oxygen partial pressure increases, the film becomes more resistive, since it comes closer to its stoichiometry). Furthermore, the window for oxygen use is incremented, when oxides based in multiple metallic components are used (binary, ternary and quaternary), also increasing the stability of the devices and the on/off ratio, independently of their structure being crystalline or amorphous. In this way, it is possible to use the same oxide both as conductor and as semiconductor.
   II - RESISTIVE THERMAL EVAPORATION OR BY ELECTRON CANNON, wherein the properties of the materials to be used depend on the quantity of reactive gas to be used and on the target composition, especially on its nature being ceramic or metallic. The process for controlling the properties of the materials produced is based on the starting conditions and on the oxidizing atmosphere in use.
   III - Chemical vapor deposition assisted by RF or UHF plasma. In this case, the elements to deposit are in the gaseous form. For example, if silicon is to be deposited, it is in silane form and is decomposed by an RF discharge under a pressure of about 10-200 Pa, using power densities between 0.03 - 2 Wcm⁻² and excitation frequencies between 13.56 - 40 MHz. Growth rates are typically between 30 - 150 nm/min. The operational thicknesses of the active semiconductor are between 200 - 300 nm.
c) TFT with memory effect. Figure 4 is a schematic view of thin film transistors with memory effect. The manufacturing processes to be used are the above mentioned, in which the dielectric material is substituted by a ferromagnetic material of greater thickness, such as PZT. In this case, the main function of the device is to store information.
d) Bridge rectifier. Figure 5 is a schematic view of a semiconductor/metal bridge rectifier in which an active semiconductor and a metal are produced in the terms and conditions above mentioned. Their electronic function is to rectify electric signals.

### D - SYSTEMS PROCESSING

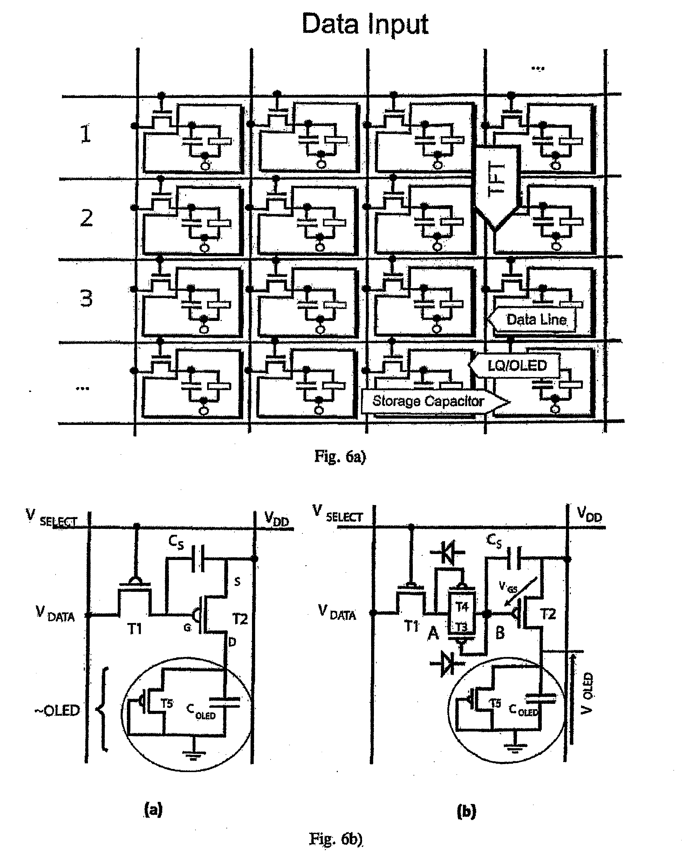

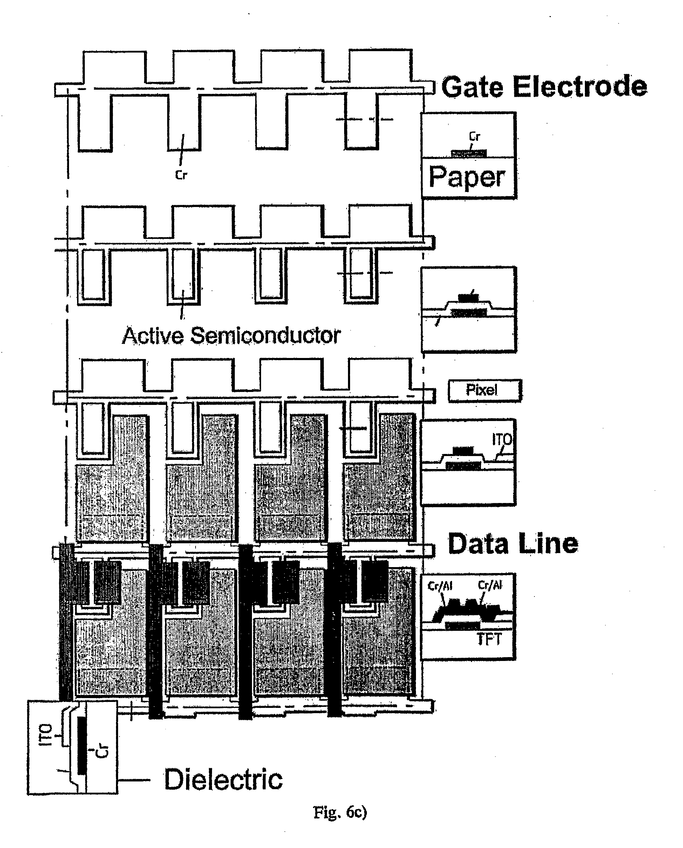

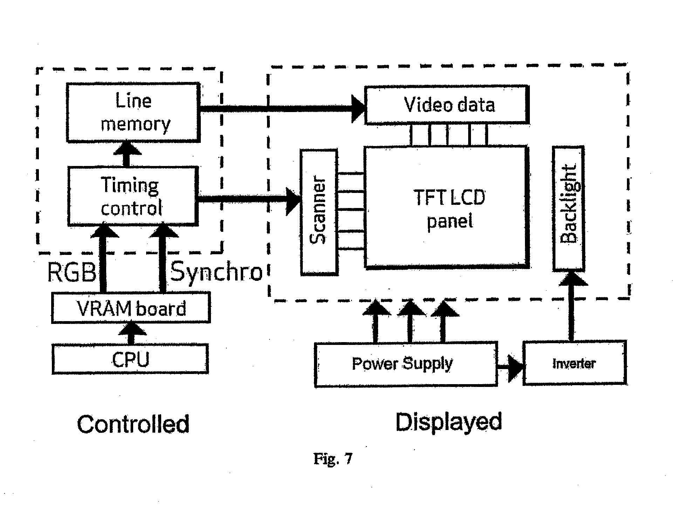

In this section we present some examples of the integration of passive and active elements aiming for a specific functional and interactive activity, such as the cases of an active matrix for addressing signals and information or of an integrated system for controlling and visualizing information, in a flat display.
a) Active matrix example. Figure 6 is a graphic representation of the mode of addressing a pixel (OLED or CL) of an active matrix, composed by active semiconductor oxides. The same TFTs, in addition to serving as switching keys, can serve to control the peripheral electronics, in terms of addressing and signal recording (function not represented in the diagram). Figure 6a) is a general schematic for a matrix used to address a liquid crystal or OLED display, while figure 6b) is the schematic for addressing an OLED. In this case (wherein the process is controlled by current, whilst with the liquid crystal the process is controlled by voltage), at least two TFTs per pixel are needed. Figure 6c) is a schematic of the manufacturing stages and masks to be used.
b) Example of an integrated system for signal visualization. Figure 7 represents an integrated system for controlling and visualizing information on a flat screen, where the storing, addressing, recording, combining and sampling functions are noticeable. This corresponds to the phase of greatest complexity and integration, to be integrated on the paper in a monolithic fashion. Thus, it will be possible to record, for example, small excerpts of a book and reproduce them, or the reader will be able to comment on what he has read and store that comment. This fusion of writing with image will allow for new products which, by the techniques embodied in the scope of the present invention, can be produced on a cellulosic substrate. In this case, the power supply will be external, using cables which are based on the principle of superconductivity, such as to maximally reduce ohmic losses, thus avoiding overheating the paper, which could otherwise be burned. To this effect, the type and composition of paper should also be selected to be the most appropriate for this application.
c) Example of an active application. As example of an application, the present invention has application in the area of printing medium, e.g. interactive posters.

The technical advantages made available by the present invention allow for the active use of paper, assuming an interactive character with the user and/or consumer. The present invention is based on a set of passive and active elements, which conduct and allow the control and the sampling of electric signals, in simple form or integrated with an image or light signal, or actuation of a sensor or sound alarm, in hybrid or monolithic form over cellulosic surfaces and their compounds, resulting in completely new electric and/or electronic components based on paper. The present invention may use in a new way oxides with the functions of conductor and semiconductor electrodes, which are fully produced at close-to-ambient temperatures. The interactive effects or animations can be embodied through several technologies, having the virtue of influencing users and consumers at the moment of use or purchase, which paves the way for applications in the area of advertising.

## Claims

1. A process for deposition of electric and/or electronic elements, by means of a deposition process selected from the group consisting of Thermal Vacuum Evaporation, Chemical Vapor Deposition or Magnetron-Assisted Cathodic Pulverization, **characterized in that** the deposition is accomplished directly on substrates of cellulosic or bio-organic paper at close-to-ambient temperatures, wherein the deposition of said electric and/or electronic elements is preceded by the steps of:
a) surface treatment of the cellulosic material substrate by UV radiation for 10 minutes;
b) vacuum surface treatment, by means of direct current or radio frequency discharge in an atmosphere of Argon, Nitrogen or Xenon, at a pressure between 10⁻² and 1 Pa, for a period of 5 minutes, and employing power densities between 0,1 and 3 Wcm⁻²;
c) surface cleaning for the removal of free nano-particles and surface activation by means of a nitrogen/hydrogen jet.

## Patentansprüche

1. Verfahren für das Auftragen von elektrischen und/oder elektronischen Elementen, mittels eines Auftragsverfahrens
ausgewählt aus der Gruppe bestehend aus thermischer Vakuumverdampfung, chemischer Dampfphasenabscheidung oder Magnetron-Kathodenzerstäubung bestehenden, **dadurch gekennzeichnet, dass** das Auftragen unmittelbar auf Substraten aus zellstoffhaltigem oder bioorganischem Papier nahe der Raumtemperatur stattfindet, wobei das Auftragen der genannten elektrischen und/oder elektronischen Elementen die Schritte:
a) Oberflächenbehandlung des zellstoffhaltigen Substrats durch UV-Strahlung während 10 Minuten;
b) Oberflächenbehandlungim Vakuum mittels Gleichstrom oder Radiofrequenz- Entladung in einer Argon-, Stickstoff- oder Xenon-Atmosphäre, bei einem Druck zwischen 10⁻² und 1 Pa während eines Zeitraums von 5 Minuten und bei Anwendung von Leistungsdichten zwischen 0,1 und 3 W/cm⁻²;
c) Oberflächenreinigung für die Entfernung von freien Nanopartikeln und Oberflächenaktivierung, mittels eines Stickstoff-/Wasserstoffstrahls,
vorausgehen.

## Revendications

1. Procédé pour le dépôt d'éléments électriques et/ou électroniques, au moyen d'un procédé de dépôt choisi parmi un groupe consistant à une vaporisation thermique sous vide, déposition en phase gazeuse par procédé chimique ou pulvérisation cathodique aidée par magnétron, **caractérisé en ce que** le dépôt est réalisé directement sur des substrats de papier cellulosiques ou bio-organiques, sous des températures proches de la température ambiante, le dépôt desdits éléments électriques et/ou électroniques étant précédé des opérations de:
a) Traitement de surface du substrat de matière cellulosique au moyen de rayonnement UV, pendant 10 minutes;
b) Traitement de surface sous vide, au moyen de courant continu ou de décharge de radiofréquence dans une atmosphère à l'argon, au nitrogène ou au xénon, sous une pression entre 10⁻² et 1 Pa, pendant une période de 5 minutes et en employant des puissances volumiques entre 0,1 et 3 W/cm⁻²;
c) Nettoyage de la surface pour l'enlèvement de nanoparticules libres et activation de la surface, au moyen d'un jet de nitrogène/hydrogène.
